# EUROPÄISCHE PATENTANMELDUNG

(11) **EP 2 259 334 A1**
(43) Veröffentlichungstag der Anmeldung: **08.12.2010**
(21) Anmeldenummer: 09162037.7
(22) Anmeldetag: 05.06.2009
(51) Int. Cl.: H01L 31/048, B32B 17/10

(54) **Photovoltaikmodule mit weichmacherhaltigen Folien geringer Kriechneigung**

(71) Anmelder: Kuraray Europe GmbH, 65926 Frankfurt am Main (DE)
(72) Erfinder: Keller, Uwe Dr., 53177 Bonn (DE); Steuer, Martin Dr., 65835 Liederbach (DE); Koichiro, Isoue, 710-8691 Okayama (JP)
(74) Vertreter: Kisters, Michael Marcus

(57) **Zusammenfassung**

Die Erfindung betrifft die Verwendung von weichmacherhaltigen, auf Polyvinylacetal basierenden Folien mit einem Polyvinylalkoholanteil im Polyvinylacetal von weniger als 18 Gew.-% mit geringer Kriechneigung zur Herstellung von Photovoltaikmodulen.

## Beschreibung

### Technisches Gebiet

Die Erfindung betrifft die Herstellung von Photovoltaikmodulen unter Verwendung von weichmacherhaltigen Folien auf Basis von Polyvinylacetal mit geringer Kriechneigung.

### Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf eine meist transparente Platte z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, UV-stabil und Feuchtigkeitsunempfindlich sein und nach dem Laminierprozess vollständig blasenfrei sein.

Als transparente Kleber können weichmacherhaltige Folien auf Basis von Polyvinylacetalen wie das aus der Verbundglasherstellung bekannte Polyvinylbutyral (PVB) verwendet werden. Die Solarzelleneinheiten werden je nach Modultyp mit einer oder mehreren PVB-Folien bedeckt oder eingekapselt und dann unter erhöhtem Druck und erhöhter Temperatur mit den gewünschten Abdeckmaterialien zu einem Laminat verbunden.

Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2, US 4,321,418, DE 20 302 045 U1, EP 1617487 A1 oder DE 35 389 86 C2 bekannt. DE 102007000818 offenbart darüber hinaus wie sich die Feuchteaufnahme und damit das Auftreten von Leckströmen durch Verwendung von Folien bestehend aus Polyvinylacetalen mit niedrigem Polyvinylalkoholgehalt in Kombination mit Weichmachern geringer Polarität reduzieren läßt.

Hierbei wirkt sich ein niedriger Polyvinylalkoholgehalt nicht nur auf die Feuchteaufnahme der Folie aus, sondern ist zugleich Vorraussetzung dafür, dass stark unpolare Weichmacher eine gute Verträglichkeit zum Polyvinylacetal aufweisen. Unpolare Weichmacher leisten einen zusätzlichen Beitrag zur Feuchtereduktion bzw. verminderten Feuchteaufnahme. Aus diesem Grund werden in DE 102007000818 vorzugsweise Polyvinylacetale mit Polyvinylalkoholgehalten kleiner/gleich 18,0 Gew.-% verwendet.

So vorteilhaft diese Wahl für die Reduktion der Feuchteaufnahme bzw. von Leckströmen ist, verschlechtern sich bei solch niedrigen Polyvinylalkoholgehalten die mechanischen Eigenschaften der Zwischenschicht in einigen Merkmalen. Eines dieser Merkmale ist das Kriechverhalten der Zwischenschicht bei erhöhter Temperatur, welches für das Langzeitverhalten von Photovoltaikmodulen von Bedeutung ist. Photovoltaikmodule werden vorzugsweise mit einer möglichst hohen Sonneneinstrahlung installiert, wodurch im Modul aufgrund der hohen Strahlungsabsorption der photoaktiven Schichten Temperaturen im Bereich 80 - 100 °C resultieren können.

Weist ein Zwischenschichtmaterial in diesem Temperaturbereich eine zu hohe Kriechneigung auf, kann dies dazu führen, dass z.B. bei einem Glas/Glas-Modul, in dem die beiden Glasplatten nur durch die Zwischenschicht mechanisch miteinander verbunden sind, bei Einwirkung hoher Temperaturen über einen längeren Zeitraum die beiden Glasplatten gegeneinander verrutschen. Zusätzlich kann es bei einer punktuellen oder zweiseitigen Halteeinrichtung des Moduls zur Durchbiegung des Moduls kommen.

Die Kriechneigung der PVB-Folie unter Temperaturbelastung hängt zwar auch vom Weichmachergehalt ab, wird aber in stärkerem Maße durch die Eigenschaften des Polyvinylacetals, wie z.B. dessen Polyvinylalkoholgehalt bestimmt.

### Aufgabe

Aufgabe der vorliegenden Erfindung ist es daher, weichmacherhaltige Folien auf Basis von Polyvinylacetal mit einem niedrigen Polyvinylalkoholgehalt aber gleichzeitig geringer Kriechneigung in einem Temperaturbereich bis zu 100°C zur Herstellung von Photovoltaikmodulen bereit zu stellen.

Es wurde gefunden das die Kriechneigung einer weichmacherhaltige Folie auf Basis von Polyvinylacetal unter Temperaturbelastung maßgeblich von dessen Polyvinylalkoholgehalt, Molgewicht, Vernetzungsgrad oder den Acetalisierungsbedingungen bei der Herstellung abhängt.

### Darstellung der Erfindung

Gegenstand der vorliegenden Erfindung sind daher Photovoltaikmodule, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung, wobei die weichmacherhaltige, auf Polyvinylacetal basierende Folie c) Polyvinylacetal mit einem Polyvinylalkoholanteil von weniger als 18 Gew.% enthält und eine Kriechneigung, bestimmt an einem Laminat mit dem Aufbau 3 mm Floatglas/ 0,76 mm Folie c) / 3 mm Floatglas, bei einer Temperatur von 100°C nach 7 Tagen von weniger als 5 mm aufweist.

Bevorzugt kann die Kriechneigung der weichmacherhaltigen, auf Polyvinylacetal basierende Folie c) in der im folgenden genauer beschriebenen Messmethode weniger als 3 mm, vorzugsweise weniger als 2 mm und am meisten bevorzugt weniger als 1 mm sein.

Durch den niedrigen Polyvinylalkoholgehalt können Weichmacher niedriger Polarität in relativ großer Menge verwendet werden, was die Feuchteresistenz der Folien weiter verbessert, ohne jedoch die Kriechneigung über Gebühr zu erhöhen.

Hierbei wirkt sich ein ausreichend niedriger Polyvinylalkoholgehalt nicht nur direkt auf die Feuchteaufnahme der Folie aus, sondern ist zugleich Vorraussetzung dafür, dass stark unpolare Weichmacher eine gute Verträglichkeit zum Polyvinylacetal aufweisen, so dass ein zusätzlicher Beitrag zur Feuchtereduktion durch Wahl eines solchen Weichmachers erhalten werden kann.

Aus diesem Grund werden für erfindungsgemäß eingesetzte Folien Polyvinylacetale mit Polyvinylalkoholgehalten kleiner 18,0 Gew.-% verwendet. Die erfindungsgemäß verwendeten Polyvinylacetale besitzen bevorzugt einen Polyvinylalkoholanteil von weniger als 16 Gew.%, besonders bevorzugt weniger als 15 Gew.% und insbesondere weniger als 13 Gew.% auf. Ein Polyvinylalkoholanteil von 10 Gew.% sollte nicht unterschritten werden.

In einer ersten Variante der Erfindung werden zur Herstellung der Folien Polyvinylacetale eingesetzt, deren Gewichtsmittel des Molekulargewichts Mw größer 110000 g/mol, bevorzugt Mw größer als 120000 g/mol und/oder deren Lösungsviskosität größer 80 mPas, bevorzugt größer 90 mPas ist. Das Molekulargewicht Mw bzw. die Lösungsviskosität wird wie in den Beipielen angegeben mittels Gelpermeationschromatographie (GPC) bzw in 5 % Lösung der Polyvinylacetale in Ethanol gemessen.

Um die Extrusionsfähigkeit der Polyvinylacetalen nicht zu verschlechtern sollte das Molekulargewicht Mw nicht größer als 500000 g/mol und/oder die Lösungsviskosität nicht größer als 300 mPas sein.

Das Molekulargewicht Mw bzw. die Lösungsviskosität stellen makroskopisch am eingesetzten Polyvinylacetal bestimmte Werte dar. Es können daher auch Mischungen aus mehreren Polyvinylacetalen verwendet werden, deren Molekulargewicht Mw bzw. Lösungsviskosität jeweils über und unter den angegebenen Grenzwerten liegen können. Das Abmischen mehrer Polyvinylacetale unter Erhalt eines Gemischs mit den genannten Untergrenzen für Molekulargewicht Mw bzw. Lösungsviskosität ist dem Fachmann bekannt.

Das erhöhte Molekulargewicht bzw. die erhöhte Lösungsviskosität kann durch Einsatz von entsprechenden Polyvinylalkoholen für die Herstellung der Polyvinylacetale erreicht werden. Bevorzugt weisen die zur Herstellung der Polyvinylacetale eingesetzten Polyvinylakohole eine Lösungsviskosität von mehr als 35 mPas auf, gemessen als 4% wässrige Lösung. Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden. Falls Mischungen von Polyvinylalkoholen eingesetzt werden, liegt deren Lösungsviskosität erfindungsgemäß oberhalb von 35 mPas.

Folien enthaltend Polyvinylacetale mit den genannten Spezifikationen für Molekulargewicht Mw bzw. Lösungsviskosität sind darüber hinaus bezüglich weiterer gewünschter Eigenschaften, wie etwa geringer Feuchteaufnahme, Reduktion von Leckströmen oder hoher optischer Transparenz gegenüber den auf Polyvinylacetal mit einem Molekulargewicht von Mw < 110000 g/mol bzw. einer Lösungsviskosität von < 80 mPas basierenden praktisch gleichwertig.

Die zur Herstellung der erfindungsgemäß verwendeten Folien erforderlichen Polyvinylacetale werden nach den bekannten Methoden durch Umsetzen von Polyvinylalkoholen mit einem entsprechenden Molgewicht und Restacetatgehalt mit einem oder mehreren Aldehyden erhalten.

Als Polyvinylalkohol können im Rahmen der vorliegenden Erfindung neben Copolymeren aus Vinylalkohol und Vinylacetat auch Terpolymere aus hydrolysierten Vinylacetat/EthylenCopolymeren eingesetzt werden. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Es ist möglich, die Acetalisierung mit Aldehyden mit 2-10 Kohlenstoffatomen, bevorzugt mit Acetaldehyd, Butyraldehyd oder Valeraldehyd durchzuführen.

In einer weiteren, zweiten Variante der Erfindung weisen die erfindungsgemäß verwendeten Polyvinylacetale durch Vernetzung über Carboxylgruppen, durch Polyaldehyde, Glutardialdehyd oder Glyoxylsäure ein erhöhtes Molekulargewicht und eine erhöhte Lösungsviskosität auf.

Vernetzte Polyvinylacetale sind z.B. über eine intramolekulare Vernetzung von Carboxylgruppen-substituierten Polyvinylacetalen erhältlich. Diese können z.B. durch die Coacetalisierung von Polyvinylalkoholen mit Polyaldehyden, Glutardialdehyd oder Glyoxylsäure hergestellt werden. Besonders bevorzugt weisen so die erhaltenen Polyvinylacetale die bereits beschriebenen Untergrenzen für Molekulargewicht Mw bzw. Lösungsviskosität auf.

Geeignete Vernetzungsmöglichkeiten für Polyvinylacetale sind sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale), EP 1622946 A1 (mit Glutardialdehyd vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen. Die Vernetzung des Polyvinylacetals wird makroskopisch über ein erhöhtes Molekulargewicht sowie eine erhöhte Viskosität einer ethanolischen Lösung wahrgenommen.

In einer dritten Variante der Erfindung werden die Eigenschaften der erfindungsgemäß verwendeten Polyvinylacetale durch die Acetalisierungsbedingungen bei deren Herstellung eingestellt. Bei der Herstellung von Polyvinylacetalen wird üblicherweise ein Gemisch von Polyvinylalkohol und Aldehyd oder Polyvinylalkohol und einer Säure wie z.B. HCl vorgelegt und durch Zugabe einer Säure bzw. Aldehyd bei einer Temperatur von 0 bis 20°C unter Ausfallen des der Polyvinylacetals umgesetzt (Fällphase). Die Fällphase beginnt mit der Zugabe der letzten Komponente (Säure oder Aldehyd) und dauert in der Regel zwischen 60 und 360 Minuten, bevorzugt zwischen 60 und 240 Minuten. Die Fällphase endet mit Beginn des Heizens auf die Endtemperatur.

Der Beginn des Heizens ist der Start der Heizphase. Anschließend wird die Reaktion bei einer Endtemperatur von 30 bis 80 °C vervollständigt, wonach die Reaktionsmischung abgekühlt und das Polyvinylacetal abgetrennt u. aufgearbeitet wird. Die Heizphase endet mit Beginn des Abkühlens und dauert in der Regel zwischen 30 und 300 Minuten.

Besonders geeignet für die erfindungsgemäßen Photovoltaikmodule sind Polyvinylacetale, hergestellt mit Verfahren mit den Schritten
- Vorlage einer Wässrigen Lösung von Polyvinylalkohol und mindestens einem Aldehyd
- Zugabe von einer Säure unter Ausfallen des Polyvinylacetals bei niedriger Temperatur (Fällphase), wobei die Fällphase zwischen 60 und 360 min, bevorzugt zwischen 60 und 240 min andauert

Alternativ kann die Fällphase auch wie folgt durchgeführt werden:
- Vorlage einer Wässrigen Lösung von Polyvinylalkohol und Säure
- Zugabe von mindestens einem Aldehyd unter Ausfallen des Polyvinylacetals bei niedriger Temperatur (Fällphase), wobei die Fällphase zwischen 60 und 360 min, bevorzugt zwischen 60 und 240 min andauert.

Die Zugabe von Säure und Aldehyd kann bei beiden Varianten auf einmal oder in Teilmengen erfolgen.

In beiden Varianten wird danach der folgende Verfahrensschritt durchgeführt (Heizphase):
- Aufheizen des Reaktionsgemisches auf eine erhöhte Temperatur
- Nachheizen bei einer erhöhten Temperatur, wobei die gesamte Heizphase zwischen 30 und 300 min andauert.

Für die vorliegende Erfindung geeignete Polyvinylacetale werden mit einer gegenüber der Heizphase deutlich zeitlich längeren Fällphase wie z.B. in DE 2838025, US 5187217, EP 1384731, WO 2004/005358, EP 0211819 JP 01318009 oder WO 2005 070669 beschrieben, hergestellt. Auf die Offenbarung dieser Patentanmeldungen wird vollumfänglich Bezug genommen. Besonders bevorzugt weisen so die erhaltenen Polyvinylacetale die bereits beschriebenen Untergrenzen für Molekulargewicht Mw bzw. Lösungsviskosität auf.

Für die vorliegende Erfindung besonders geeignete Polyvinylacetale werden in einer vierten Variante der Erfindung durch die Kombination eines Herstellprozesses mit einer langen Fällphase wie in der dritten Variante mit einer Vernetzungsreaktion z.B. durch thermische Selbstvernetzung von Carboxylgruppenhaltigen Polyvinylacetalen, durch Vernetzung des Polyvinylacetals mit Polyaldehyden, Glutardialdehyd oder Glyoxylsäure erhalten. Die Vernetzungsreaktion kann während der Herstellung des Polyvinylacetals (d.h. der Umsetzung von Polyvinylalkohol mit Aldehyd) durch gleichzeitige Zugabe des Aldehyds und des Vernetzungsmittels oder auch in einem separaten Reaktionsschritt wie der Zugabe des Vernetzungsmittels in die Extrusion der weichmacherhaltigen Folie erfolgen. Besonders bevorzugt weisen die so erhaltenen Polyvinylacetale die bereits beschriebenen Untergrenzen für Molekulargewicht Mw bzw. Lösungsviskosität auf.

Unabhängig von der Herstellmethode und von einer Vernetzung weisen die erfindungsgemäß eingesetzten Polyvinylacetale neben den Acetaleinheiten noch aus Vinylacetat und Vinylalkohol resultierende Einheiten auf sowie ggf. weitere Comonomere.

Der Polyvinylacetatanteil der erfindungsgemäß verwendeten Polyvinylacetale liegt bevorzugt unter 14 Gew.%, besonders bevorzugt unter 10 Gew.% bzw unter 5 Gew.% und insbesondere unter 2 Gew.%. Aus dem Polyvinylalkoholanteil und dem Restacetatgehalt kann der Acetalisierungsgrad rechnerisch ermittelt werden.

Die erfindungsgemäß eingesetzten Folien weisen bevorzugt auch unter humiden Bedingungen im Randbereich Feuchte- bzw. Wassergehalte von maximal 2.3 Gew.-%, maximal 2.0 Gew.%, maximal 1.8 Gew.% und besonders bevorzugt von maximal 1.5 Gew.% auf. Photovoltaikmodule mit Folien dieser Art können sehr nahe an den Folienrand mit photosensitiven Halbleiterschichten belegt werden und weisen damit eine erhöhte Flächen- und Stromausbeute auf.

Bevorzugt weisen die erfindungsgemäß eingesetzten Folien bei einer Umgebungsfeuchte von 85% rF bei 23°C einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Die Feuchteaufnahme und der spezifische Widerstand von weichmacherhaltigen Folien auf Basis von Polyvinylacetal werden zusätzlich vom Anteil und der Polarität bzw. der weichmachenden Wirkung des verwendeten Weichmachers bestimmt. Somit kann die Feuchteaufnahme und der spezifische Widerstand der Folie auch in einfacher Weise über den Weichmacher eingestellt werden.

Bevorzugt weisen die Folien einen Weichmachergehalt im Bereich 18 bis 32 Gew.-%, bevorzugt im Bereich 20 bis 30 Gew.-%, besonders bevorzugt im Bereich 22 bis 28 Gew.-% und insbesondere im Bereich 24 bis 27 Gew.-% auf. Erfindungsgemäße Folien bzw. Photovoltaikmodule können einen oder mehrere Weichmacher enthalten.

Erfindungsgemäß besonders geeignet sind Weichmacher, deren Polarität, ausgedrückt durch die Formel 100 x 0/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung 100 x 0/(C+H) | | |
|---|---|---|---|
| Di-2-ethylhexylsebacat | | (DOS) | 5,3 |
| 1,2-Cyclohexandicarbonsäurediisononylester | | (DINCH) | 5,4 |
| Di-2-ethylhexyladipat | | (DOA) | 6,3 |
| Di-2-ethylhexylphthalat | | (DOP) | 6,5 |
| Dihexyladipat | | (DHA) | 7,7 |
| Dibutylsebacat | | (DBS) | 7,7 |
| Di-2-butoxyethylsebacat | | (DBES) | 9,4 |
| Triethylenglykol-bis-2-ethylhexanoat | | (3G8) | 9,4 |

Weniger geeignet sind die folgenden Weichmacher

| Name | Abkürzung 100 x 0/(C+H) | |
|---|---|---|
| Triethylenglykol-bis-n-heptanoat | 3G7 | 10,3 |
| Tetraethylenglykol-bis-n-heptanoat | 4G7 | 10,9 |
| Di-2-butoxyethyladipat | DBEA | 11,5 |
| Di-2-butoxyethoxyethyladipat | DBEEA | 12,5 |

Das Haftungsvermögen von Polyvinylacetalfolien an Glas wird üblicherweise durch die Zugabe von Haftungsregulatoren wie z. B. die in WO 03/033583 A1 offenbarten Alkali- und/oder Erdalkalisalze von organischen Säuren eingestellt. Als besonders geeignet haben sich Kaliumacetat und/oder Magnesiumacetat herausgestellt. Zudem enthalten Polyvinylacetale aus dem Herstellungsprozess häufig Alkali-und/oder Erdalkalisalze von anorganischen Säuren, wie z.B. Natriumchlorid.

Da Salze ebenfalls einen Einfluss auf den spezifischen Widerstand haben, ist der Einsatz von weichmacherhaltigen, auf Polyvinylacetal basierenden Folien mit weniger als 50 ppm, besonders bevorzugt mit weniger als 30 ppm und insbesondere mit weniger als 20 ppm Metallionen zweckmäßig. Dies kann durch entsprechende Waschverfahren des Polyvinylacetals und durch die Verwendung besonders gut wirkender Antihaftmittel wie die dem Fachmann bekannten Magnesium-, Calcium- und/oder Zinksalze organischer Säuren (z.B. Acetate) erreicht werden.

Weiterhin kann die möglicherweise vom Wassergehalt der Folie abhängende Ionenbeweglichkeit und damit der spezifische Widerstand durch den Zusatz von pyrogener Kieselsäure beeinflusst werden. Bevorzugt enthalten die weichmacherhaltigen, auf Polyvinylacetal basierenden Folien 0.001 bis 15 Gew.-%, bevorzugt 0.5 bis 5 Gew.% pyrogenes SiO₂.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

In einer Variante der erfindungsgemäßen Photovoltaikmodule werden die photosensitiven Halbleiterschichten auf der Abdeckung d) aufgebracht (z.B. durch Aufdampfen, Gasphasenabscheidung, Sputtern oder Nassabscheidung) und durch eine Folie c) mit der Abdeckung a) verklebt.

Alternativ werden die photosensitiven Halbleiterschichten zwischen zwei Folien c) eingebettet und so mit den Abdeckungen a) und d) verklebt.

Die Dicke der auf weichmacherhaltigem Polyvinylacetal basierenden Folien liegt zwischen 0,2 und 2,5 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Bei Dünnschicht-Solarmodulen ist die photosensitive Halbleiterschicht direkt auf einen Träger aufgebracht. Eine Einkapselung ist hier nicht möglich. Daher wird der Schichtkörper aus einem Träger (z.B. der rückwärtigen Abdeckung) mit der photosensitiven Halbleiterschicht und der transparenten Frontabdeckung durch mindestens eine zwischen gelegte, auf weichmacherhaltigem Polyvinylacetal basierende Folie c) zusammengelegt und durch diese bei erhöhter Temperatur verklebt. Alternativ kann die photosensitive Halbleiterschicht auf die transparente Frontabdeckung als Träger aufgebracht und mit der der rückwärtigen Abdeckung durch mindestens eine zwischen gelegte, auf weichmacherhaltigem Polyvinylacetal basierende Folie c) verklebt sein.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Weiterhin ist Gegenstand der Erfindung die Verwendung weichmacherhaltigen, auf Polyvinylacetal basierenden Folie c) mit einem Polyvinylalkoholanteil des Polyvinylacetals von weniger als 18 Gew.% und einer Kriechneigung, bestimmt an einem Laminat mit dem Aufbau aus 3 mm Floatglas/ 0,76 mm Folie c) / 3 mm Floatglas, bei einer Temperatur von 100°C nach 7 Tagen von weniger als 5 mm zur Herstellung von Photovoltaikmodulen. Die Photovoltaikmodule umfassen bevorzugt ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung

Zur Herstellung der Photovoltaikmodule können Folien c) mit den beschriebenen bevorzugten Ausführungsformen verwendet werden.

Erfindungsgemäße Photovoltaikmodule können als Fassadenbauteil, Dachflächen, Wintergartenabdeckung, Schallschutzwand, Balkon-oder Brüstungselement oder als Bestandteil von Fensterflächen verwendet werden.

### Messmethoden:

Die Bestimmung der Glasübergangstemperatur der Folie erfolgt mittels Dynamischer Differenzkalorimetrie (DSC) gemäß DIN 53765 unter Verwendung einer Heizrate von 10K/min im Temperaturintervall -50 °C - 150°C. Es wird eine erste Heizrampe, gefolgt von einer Kühlrampe, gefolgt von einer zweiten Heizrampe gefahren. Die Lage der Glasübergangstemperatur wird an der der zweiten Heizrampe zugehörigen Messkurve nach DIN 51007 ermittelt. Der DIN-Mittelpunkt (Tg DIN) ist definiert als Schnittpunkt einer Horizontalen auf halber Stufenhöhe mit der Messkurve. Die Stufenhöhe ist durch den vertikalen Abstand der beiden Schnittpunkte der Mitteltangente mit den Basislinien der Messkurve vor und nach Glasumwandlung definiert.

Die Bestimmung des Fließverhaltens der Folie erfolgt als Schmelzindex (Massenfluss: MFR) nach ISO 1133 auf einem entsprechenden Gerät, z.B. der Firma Göttfert, Modell MI2. Der MFR-wert wird bei den entsprechenden Temperaturen von z.B 100 °C und 140°C mit der 2 mm Düse bei Gewichtsbelastung von 21,6 kg in gramm pro 10 minuten (g/10 min) angegeben.

Die Messung des spezifischen Durchgangswiderstandes der Folie erfolgt in Ohm*cm gemäß DIN IEC 60093 bei definierter Temperatur und Umgebungsfeuchte (23 °C und 85% rF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmeßgerät ISO-Digi 5kV von der Firma Amprobe verwendet. Die Prüfspannung betrug 2,5kV, die Wartezeit nach Anlegen der Prüfspannung bis zur Meßwerterfassung 60 sek. Damit ein ausreichender Kontakt zwischen den flachen Platten der Meßelektrode und der Folie gewährleistet ist, sollte deren Oberflächenrauhikgkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt.

Die Analyse des Metallionengehaltes erfolgte durch Atomabsorptionsspekroskopie (AAS).

Das Molekulargewicht Mw (= Gewichtsmittel) der Polyvinylacetale wurde mittels Gelpermeationschromatographie (GPC) in Eisessig unter Verwendung von RI-Detektoren bestimmt. Die Kalibrierung der Detektoren erfolgte mittels PVB-Eichstandards, deren Absolutwerte mittels statischer Lichtstreuung ermittelt wurden.

Die Messung der Lösungsviskosität der Polyvinylacetale erfolgte gemäß DIN 53015 bei 20°C in einem Gemisch aus 95 Teilen Ethanol u. 5 Teilen Wasser. Der Feststoffgehalt der Viskositätslösung betrug 5 Gew.%.

Die Messung der Lösungsviskosität der Polyvinylalkohole erfolgte gemäß DIN 53015 bei 20°C in Wasser. Der Feststoffgehalt der Viskositätslösung betrug 4 Gew.%.

Der Wasser- bzw. Feuchtegehalt der Folien wird mit der Karl-Fischer-Methode in Gew.%. Zur Simulation des Auffeuchteverhaltens unter humiden Bedingungen wird die Folie zuvor 24h bei 23 °C und 85% rF gelagert. Die Methode kann sowohl an der unlaminierten Folie als auch an einem laminierten Photovoltaikmodul in Abhängigkeit vom Abstand zum Rand der Folie durchgeführt werden.

### Test auf Kriechneigung

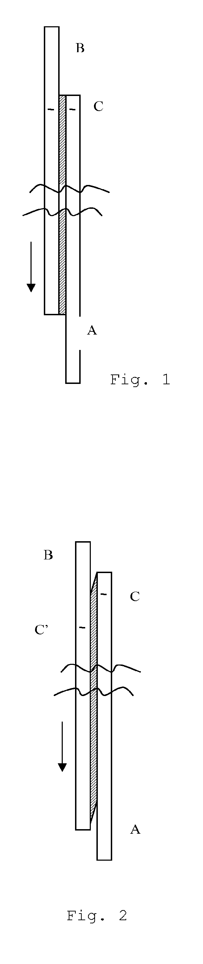

Die Kriechneigung der Folien wird an Testlaminaten bestimmt, welche aus zwei Stücken Floatglas der Dicke 3 mm und Kantenabmessung 150 x 300 mm mit der in Dicke 0.76 mm dazwischen laminierten Folie so hergestellt werden, dass die beiden Gläser in der Länge einen Versatz von 2 cm zueinander aufweisen (A/B in Fig. 1 und 2). Die auf ihre Kriechneigung zu untersuchende Folie wird vor dem Herstellen des Laminates in einem Klima von 23 °C / 23 % rF über Nacht konditioniert.

Die beiden überstehenden Glasabschnitte sind nicht mit Folie bedeckt, d.h. die einlaminierte Zwischenschicht hat lediglich eine Länge von 28 cm. Die Testlaminate werden mit einem Stift von beiden Seiten genau gegenüberliegend mit Querstrichen markiert, anhand derer später der durch Abrutschen resultierende Versatz leicht ausgemessen werden kann. (C in Fig.1) Die Testlaminate werden in einem Heizschrank bei 100 °C in der Vertikalen so aufgestellt bzw. befestigt, dass das vordere, nicht bodenberührende Glas (B in Fig. 1 und 2) unter seinem Eigengewicht frei abgleiten kann, dass heißt, nur durch die Zwischenschichtfolie gehalten wird und auch nur zu dieser Kontakt hat, so dass das Ergebnis nicht durch Reibungseffekte verfälscht wird. Die Testlaminate werden nach Ablauf von 7 Tagen (einer Woche) auf etwaigen Versatz hin untersucht indem der Abstand zwischen den beiden Markierungen mit einem Lineal ausgemessen wird. (C und C' in Fig. 2)

### Beispiele

Es wurden Folien der Dicke 0,76 mm mit den Mischungen der in den nachfolgenden Tabellen aufgeführten Zusammensetzungen hergestellt und als Laminat zwischen 2 Scheiben Weißglas (Optiwhite) der Stärke 3 mm auf ihre Eignung zur Herstellung von Photovoltaikmodulen d.h. ihre Kriechneigung und den elektrische Durchgangswiderstand untersucht.

Es zeigt sich, dass die erfindungsgemäß verwendeten Folien gut zu Photovoltaikmodulen verarbeitet werden können, da sie die Solarzellen vollständig einkapseln. Demgegenüber zeigen die niedrigen Kriechwerte (= Abgleiten) bei 100 °C eine geringe Fliessfähigkeit bei dieser Temperatur an, sodass ein gegenüber Umwelt- und mechanischen Einflüssen stabiles Modul erhalten wird

Folien mit den beschriebenen Fließfähigkeiten sind zur Herstellung von Photovoltaikmodulen besonders geeignet, da sie kein Abgleiten der Deckschichten gegenüber der Klebefolie zeigen, sich aber dennoch gut verarbeiten lassen.

Es bedeuten
- DINCH: 1,2-Cyclohexandicarbonsäurediisononylester
- 3G8: Triethylenglykol-bis-2-ethylhexanoat
- PVB: Polyvinylbutyral mit dem angegebenen PVA-Gehalt

### Vergleichsbeispiel 1:

100 Gewichtsteile des Polyvinylalkohols Mowiol 28-99 (Handelsprodukt von Kuraray Europe GmbH) wurden in 1075 Gewichtsteilen Wasser unter Erwärmen auf 90 °C gelöst. Es wurden bei einer Temperatur von 40 °C 56,8 Gewichtsteile n-Butyraldehyd und bei einer Temperatur von 12 °C unter Rühren innerhalb 6 min 75 Gewichtsteile 20 %ige Salzsäure zugegeben, wonach das Polyvinylbutyral (PVB) ausfiel. Die Mischung wurde danach unter Rühren noch 15 min bei 12 °C gehalten, danach innerhalb 80 min auf 69°C erwärmt und bei dieser Temperatur für 120 min gehalten. Das PVB wurde nach Abkühlen auf Raumtemperatur abgetrennt, mit Wasser neutral gewaschen und getrocknet. Es wurde ein PVB mit einem Polyvinylakoholgehalt von 20,2 Gew.% und einem Polyvinylacetatgehalt von 1,5 Gew.% erhalten.

290 g des so erhaltenen PVB und 100 g Weichmacher 3G8 und 10 g Weichmacher DBEA wurden in einem Labormischer (Hersteller: Brabender, Modell 826801) gemischt. Die erhaltene Mischung wurde zu Flachfolie mit einer Dicke von 0,8 mm extrudiert. Die Extrusion erfolgte auf einem Doppelschneckenextruder mit gegenlaufenden Schnecken (Hersteller: Haake, System Rhecord 90), ausgerüstet mit Schmelzepumpe und Breitschlitzdüse. Die Zylindertemperatur des Extruders betrug 220 °C, die Düsentemperatur betrug 150°C.

### Vergleichsbeispiel 2:

Bei der Polymersynthese wurden 63,9 Gewichtsteile n-Butyraldehyd eingesetzt. Bei der Folienherstellung wurden 370 g PVB und 130 g Weichmacher DINCH eingesetzt. Das weitere Vorgehen war gemäß Vergleichsbeispiel 1.

### Vergleichsbeispiele 3 - 4:

Bei der Polymersynthese wurden 66,3 und 68,4 Gewichtsteile n-Butyraldehyd eingesetzt. Das weitere Vorgehen war gemäß Vergleichsbeispiel 2.

### Beispiele 1,2 u. 3:

Bei der Polymersynthese wurden 100 Gewichtsteile des Polyvinylalkohols Mowiol 56-98, (Handelsprodukt von Kuraray Europe GmbH), 1333 Gewichtsteile Wasser und 67,9, 68,4 und 69 Gewichtsteile n-Butyraldehyd eingesetzt. Das weitere Vorgehen war gemäß Vergleichsbeispiel 2.

### Beispiele 4 u. 5:

Bei der Polymersynthese wurden 100 Gewichtsteile des Polyvinylalkohols Kuraray Poval 624 (Handelsprodukt von Kuraray Co. Ltd.), 1333 Gewichtsteile Wasser, 100 Gewichtsteile 20 %ige Salzsäure und 70 bzw. 73 Gewichtsteile n-Butyraldehyd eingesetzt. Das weitere Vorgehen war gemäß Vergleichsbeispiel 2.

### Vergleichsbeispiel 5:

Bei der Folienherstellung wurde eine Mischung von 333 g PVB aus Vergleichsbeispiel 4 und 37 g PVB aus Beispiel 2 eingesetzt. Das weitere Vorgehen war gemäß Vergleichsbeispiel 2.

### Beispiel 6:

Bei der Folienherstellung wurde eine Mischung von 259 g PVB aus Vergleichsbeispiel 4 und 111 g PVB aus Beispiel 2 eingesetzt. Das weitere Vorgehen war gemäß Vergleichsbeispiel 2.

### Beispiel 7:

Bei der Folienherstellung wurde eine Mischung von 185 g PVB aus Vergleichsbeispiel 4 und 185 g PVB aus Beispiel 2 eingesetzt. Das weitere Vorgehen war gemäß Vergleichsbeispiel 2.

### Beispiel 8:

Bei der Folienherstellung wurde eine Mischung von 185 g PVB aus Vergleichsbeispiel 4 und 185 g PVB aus Beispiel 3 eingesetzt. Das weitere Vorgehen war gemäß Vergleichsbeispiel 2.

### Beispiele 9 - 12:

Bei der Polymersynthese wurden 68,4 Gewichtsteile n-Butyraldehyd sowie zusätzlich 0,02, 0,04, 0,06 und 0,08 Gewichtsteile Glutaraldehyd eingesetzt. Das weitere Vorgehen war gemäß Vergleichsbeispiel 2.

### Beispiele 13 - 14:

Bei der Polymersynthese wurden 100 Gewichtsteile des Polyvinylalkohols Mowiol 30-92, (Handelsprodukt von Kuraray Europe GmbH), 1075 Gewichtsteile Wasser, 67,1 Gewichtsteile n-Butyraldehyd, 100 Gewichtsteile 20 %ige Salzsäure und 0,04 bzw. 0,08 Gewichtsteile Glutaraldehyd eingesetzt. Das weitere Vorgehen war gemäß Vergleichsbeispiel 2.

### Beispiel 15:

100 Gewichtsteile des Polyvinylalkohols Mowiol 28-99 (Handelsprodukt von Kuraray Europe GmbH) wurden in 1075 Gewichtsteilen Wasser unter Erwärmen auf 90 °C gelöst. Es wurden bei einer Temperatur von 40 °C 68,4 Gewichtsteile n-Butyraldehyd und bei einer Temperatur von 12 °C unter Rühren innerhalb 15 min 15 Gewichtsteile 20 %ige Salzsäure zugegeben, wonach das Polyvinylbutyral (PVB) ausfiel. Die Mischung wurde danach unter Rühren 60 min bei 12 °C gehalten. Danach wurden innerhalb von 40 min weitere 50 Gewichtsteile 20 %ige Salzsäure zugegeben. Die Mischung wurde danach unter Rühren noch 15 min bei 12 °C gehalten, danach innerhalb 80 min auf 69°C erwärmt und bei dieser Temperatur für 120 min gehalten.
Das weitere Vorgehen war gemäß Vergleichsbeispiel 2.

### Beispiele 16 - 17:

Die Pause nach Zugabe der ersten Teilmenge der Säure betrug 120 bzw. 180 min. Das weitere Vorgehen war gemäß Beispiel 15.

### Beispiel 18:

100 Gewichtsteile des Polyvinylalkohols Mowiol 28-99 (Handelsprodukt von Kuraray Europe GmbH) wurden in 1075 Gewichtsteilen Wasser unter Erwärmen auf 90 °C gelöst. Es wurden bei einer Temperatur von 40 °C 68,4 Gewichtsteile n-Butyraldehyd und 0,03 Gewichtsteile Glutaraldehyd zugegeben. Bei einer Temperatur von 12 °C wurden unter Rühren innerhalb 6 min 75 Gewichtsteile 20 %ige Salzsäure zugegeben, wonach das Polyvinylbutyral (PVB) ausfiel. Die Mischung wurde danach unter Rühren noch 120 min bei 12 °C gehalten, danach innerhalb 80 min auf 69°C erwärmt und bei dieser Temperatur für 120 min gehalten. Das weitere Vorgehen war gemäß Vergleichsbeispiel 2.

### Beispiel 19:

100 Gewichtsteile des Polyvinylalkohols Mowiol 28-99 (Handelsprodukt von Kuraray Europe GmbH) wurden in 1075 Gewichtsteilen Wasser unter Erwärmen auf 90 °C gelöst. Es wurden bei einer Temperatur von 40 °C 68,4 Gewichtsteile n-Butyraldehyd und 0,03 Gewichtsteile Glutaraldehyd zugegeben.
Bei einer Temperatur von 12 °C wurden unter Rühren innerhalb 15 min 15 Gewichtsteile 20 %ige Salzsäure zugegeben, wonach das Polyvinylbutyral (PVB) ausfiel. Die Mischung wurde danach unter Rühren 120 min bei 12 °C gehalten. Danach wurden innerhalb von 40 min 50 Gewichtsteile 20 %ige Salzsäure zugegeben. Die Mischung wurde danach unter Rühren noch 15 min bei 12 °C gehalten, danach innerhalb 80 min auf 69°C erwärmt und bei dieser Temperatur für 120 min gehalten. Das weitere Vorgehen war gemäß Vergleichsbeispiel 2.

### Beispiele 20 - 21:

100 Gewichtsteile des Polyvinylalkohols Mowiol 30-92 (Handelsprodukt von Kuraray Europe GmbH) wurden in 1075 Gewichtsteilen Wasser unter Erwärmen auf 90 °C gelöst. Es wurden bei einer Temperatur von 40 °C 67,1 Gewichtsteile n-Butyraldehyd und 0,06 Gewichtsteile Glutaraldehyd zugegeben. Bei einer Temperatur von 12 °C wurden unter Rühren innerhalb 6 min 100 Gewichtsteile 20 %ige Salzsäure zugegeben, wonach das Polyvinylbutyral (PVB) ausfiel. Die Mischung wurde danach unter Rühren noch 60 bzw. 120 min bei 12 °C gehalten, danach innerhalb 80 min auf 69°C erwärmt und bei dieser Temperatur für 120 min gehalten. Das weitere Vorgehen war gemäß Vergleichsbeispiel 2.

**Tabelle 1**

| Beispiel | VG 1 | VG 2 | VG 3 | VG 4 | VG 5 |
|---|---|---|---|---|---|
| PVB | | | | | |
| Viskosität PVA 4% (mPa.s) | 27,06 | 27,06 | 27,06 | 27,06 | - |
| Fällphase [min] | 21 | 21 | 21 | 21 | - |
| Heizphase [min] | 200 | 200 | 200 | 200 | - |
| Polyvinylalkoholgehalt [w%] | 20,2 | 16,0 | 15,0 | 14,3 | 14,4 |
| Polyvinylacetatgehalt [w%] | 1,5 | 0,9 | 1,1 | 0,9 | 1,0 |
| Butyral Gehalt [w%] | 78,3 | 83,1 | 83,9 | 84,8 | 84,6 |
| Polyvinylalkoholgehalt [mol%] | 29,1 | 23,5 | 22,2 | 21,2 | 21,4 |
| Polyvinylacetatgehalt [mol%] | 1,1 | 0,7 | 0,8 | 0,7 | 0,8 |
| Butyral Gehalt [mol%] | 69,8 | 75,8 | 77,0 | 78,1 | 77,9 |
| Viskosität PVB 5 % (mPa.s) | 81,4 | 68,2 | 70 | 72,9 | 90,1 |
| | | | | | |
| Film | | | | | |
| Weichmacher | 3G8/DBEA (10:1) | DINCH | DINCH | DINCH | DINCH |
| Weichmacher [w%] | 27,5 | 26,0 | 26,0 | 26,0 | 26,0 |
| Tg, Midpoint DIN [°C] | 18,8 | 24,99 | 23,47 | 21,73 | - |
| Mw, PVB [g/mol] | 103000 | 103800 | 103000 | 101950 | 106000 |
| MFR 100°C/21,6 kg [mg/10min.] | 165 | 397 | 465 | 378 | 351 |
| Elektrischer Durchgangs-widerstand in Ohm*cm | 1,20E+11 | 7,20E+13 | 2,80E+13 | 4,30E+13 | 3,00E+13 |
| Wassergehalt nach Karl-Fischer in Gew.% | 3,09 | 1,87 | 1,73 | 1,87 | 1,67 |
| Abgleiten in mm | 0 | 8,5 | 9 | 7 | 5 |

**Tabelle 2**

| Beispiel | B1 | B2 | B3 | B4 | B5 | B6 |
|---|---|---|---|---|---|---|
| PVB | | | | | | |
| Viskosität PVA 4% (mPa.s) | 56,36 | 56,36 | 56,36 | 55,92 | 55,92 | - |
| Fällphase [min] | 21 | 21 | 21 | 21 | 21 | - |
| Heizphase [min] | 200 | 200 | 200 | 200 | 200 | - |
| Polyvinylalkoholgehalt [w%] | 15,6 | 15,0 | 14,1 | 13,5 | 12,7 | 14,5 |
| Polyvinylacetatgehalt [w%] | 2,0 | 2,1 | 1,9 | 5,4 | 5,7 | 1,3 |
| Butyral Gehalt [w%] | 82,4 | 83,0 | 84,0 | 81,1 | 81,6 | 84,2 |
| Polyvinylalkoholgehalt [mol%] | 23,0 | 22,2 | 21,0 | 20,3 | 19,2 | 21,5 |
| Polyvinylacetatgehalt [mol%] | 1,5 | 1,6 | 1,5 | 4,1 | 4,4 | 1,0 |
| Butyral Gehalt [mol%] | 75,5 | 76,2 | 77,6 | 75,6 | 76,4 | 77,5 |
| Viskosität PVB 5 % (mPa.s) | 179,8 | 177,3 | 177,8 | 195,8 | 205,9 | 105,5 |
| | | | | | | |
| Film | | | | | | |
| Weichmacher | DINCH | DINCH | DINCH | DINCH | DINCH | DINCH |
| Weichmacher [w%] | 26,0 | 26,0 | 26 | 26 | 26 | 26,0 |
| Tg, Midpoint DIN [°C] | 23,81 | 24,16 | - | - | - | - |
| Mw, PVB [g/mol] | 143300 | 144300 | 143775 | 150800 | 150200 | 113500 |
| MFR 100°C/21,6 kg [mg/10min.] | 88 | 83 | 97 | 84 | 97 | 263 |
| Elektrischer Durchgangs-widerstand in Ohm*cm | 4,70E+13 | 3,50E+13 | 7E+13 | 1,10E+14 | 9,40E+13 | 4,10E+13 |
| Wassergehalt nach Karl-Fischer in Gew.% | 1,79 | 1,76 | 1,7 | 1,61 | 1,55 | 1,69 |
| Abgleiten in mm | 1 | 1 | 0 | 1 | 1 | 2 |

**Tabelle 3**

| Beispiel | B7 | B8 | B9 | B10 | B11 | B12 |
|---|---|---|---|---|---|---|
| PVB | - | - | | | | |
| Viskosität PVA 4% (mPa.s) | - | - | 26,8 | 27,06 | 27,06 | 27,06 |
| Fällphase [min] | - | - | 21 | 21 | 21 | 21 |
| Heizphase [min] | - | - | 200 | 200 | 200 | 200 |
| Polyvinylalkoholgehalt [w%] | 14,7 | 14,2 | 14,5 | 14,5 | 14,2 | 14,4 |
| Polyvinylacetatgehalt [w%] | 1,5 | 1,4 | 1,2 | 0,9 | 1,0 | 0,9 |
| Butyral Gehalt [w%] | 83,8 | 84,4 | 84,3 | 84,6 | 84,8 | 84,7 |
| Polyvinylalkoholgehalt [mol%] | 21,8 | 21,1 | 21,5 | 21,6 | 21,2 | 21,3 |
| Polyvinylacetatgehalt [mol%] | 1,1 | 1,1 | 0,9 | 0,7 | 0,8 | 0,7 |
| Butyral Gehalt [mol%] | 77,1 | 77,8 | 77,6 | 77,8 | 78,1 | 78,0 |
| Viskosität PVB 5 % (mPa.s) | 120 | 120 | 79,8 | 90,9 | 103,7 | 120,5 |
| | | | | | | |
| Film | | | | | | |
| Weichmacher | DINCH | DINCH | DINCH | DINCH | DINCH | DINCH |
| Weichmacher [w%] | 26,0 | 26 | 26,0 | 26,0 | 26,0 | 26,0 |
| Tg, Midpoint DIN [°C] | - | - | 23,69 | - | - | - |
| Mw, PVB [g/mol] | 122300 | 122400 | 111450 | 127200 | 141850 | 159600 |
| MFR 100°C/21,6 kg [mg/10min.] | 172 | 180 | 340 | 227 | 189 | 105 |
| Elektrischer Durchgangs-widerstand in Ohm*cm | 4,50E+13 | 7,5E+13 | 9,70E+13 | 3,70E+13 | 5,50E+13 | 4,60E+13 |
| Wassergehalt nach Karl-Fischer in Gew.% | 1,69 | 1,64 | 1,62 | 1,63 | 1,72 | 1,67 |
| Abgleiten in mm | 1 | 0 | 4 | 1 | 1 | 0 |

**Tabelle 4**

| Beispiel | B13 | B14 | B15 | B16 | B17 | B18 |
|---|---|---|---|---|---|---|
| PVB | | | | | | |
| Viskosität PVA 4% (mPa.s) | 30,75 | 30,75 | 27,06 | 27,06 | 27,06 | 27,06 |
| Fällphase [min] | 21 | 21 | 115 | 175 | 235 | 126 |
| Heizphase [min] | 200 | 200 | 200 | 200 | 200 | 200 |
| Polyvinylalkoholgehalt [w%] | 11,1 | 11,3 | 14,5 | 15,1 | 14,8 | 15,0 |
| Polyvinylacetatgehalt [w%] | 9,0 | 8,8 | 1,0 | 0,9 | 0,9 | 1,0 |
| Butyral Gehalt [w%] | 79,9 | 79,9 | 84,5 | 84,0 | 84,2 | 84,0 |
| Polyvinylalkoholgehalt [mol%] | 17,0 | 17,3 | 21,5 | 22,3 | 22,0 | 22,2 |
| Polyvinylacetatgehalt [mol%] | 7,1 | 6,9 | 0,7 | 0,7 | 0,7 | 0,8 |
| Butyral Gehalt [mol%] | 75,9 | 75,8 | 77,7 | 77,0 | 77,3 | 77,0 |
| Viskosität PVB 5 % (mPa.s) | 111,6 | 152,1 | 83,6 | 87,8 | 88,3 | 90,4 |
| | | | | | | |
| Film | | | | | | |
| Weichmacher | DINCH | DINCH | DINCH | DINCH | DINCH | DINCH |
| Weichmacher [w%] | 26 | 26 | 26,0 | 26 | 26 | 26 |
| Tg, Midpoint DIN [°C] | - | - | 22,08 | - | - | - |
| Mw, PVB [g/mol] | 141800 | 172400 | 102525 | 103225 | 102075 | 116700 |
| MFR 100°C/21,6 kg [mg/10min.] | 221 | 103 | 156 | 131 | 116 | 253 |
| Elektrischer Durchgangs-widerstand in Ohm*cm | 4,90E+13 | 5,60E+13 | 9,20E+13 | 1,2E+14 | 7,5E+13 | 4,10E+13 |
| Wassergehalt nach Karl-Fischer in Gew.% | 1,52 | 1,54 | 1,64 | 1,68 | 1,7 | 1,78 |
| Abgleiten in mm | 3 | 0 | 1 | 0 | 0 | 2 |

**Tabelle 5**

| Beispiel | B19 | B20 | B21 |
|---|---|---|---|
| PVB | | | |
| Viskosität PVA 4% (mPa.s) | 27,06 | 30,75 | 30,75 |
| Fällphase [min] | 175 | 106 | 166 |
| Heizphase [min] | 200 | 200 | 200 |
| Polyvinylalkoholgehalt [w%] | 14,7 | 11,8 | 11,6 |
| Polyvinylacetatgehalt [w%] | 1,1 | 9,2 | 9,6 |
| Butyral Gehalt [w%] | 84,2 | 79,0 | 78,8 |
| Polyvinylalkoholgehalt [mol%] | 21,8 | 18,0 | 17,8 |
| Polyvinylacetatgehalt [mol%] | 0,8 | 7,2 | 7,5 |
| Butyral Gehalt [mol%] | 77,4 | 74,8 | 74,7 |
| Viskosität PVB 5 % (mPa.s) | 102,6 | 131,6 | 124,2 |
| | | | |
| Film | | | |
| Weichmacher | DINCH | DINCH | DINCH |
| Weichmacher [w%] | 26 | 26 | 26 |
| Tg, Midpoint DIN [°C] | - | - | - |
| Mw, PVB [g/mol] | 115400 | 160500 | 155400 |
| MFR 100°C/21,6 kg [mg/10min.] | 106 | 121 | 181 |
| Elektrischer Durchgangs-widerstand in Ohm*cm | 1,30E+13 | 8,90E+13 | 2,00E+14 |
| Wassergehalt nach Karl-Fischer in Gew.% | 1,68 | 1,54 | 1,5 |
| Abgleiten in mm | 0 | 0 | 1 |

## Patentansprüche

1. Photovoltaikmodul, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung
**dadurch gekennzeichnet, dass** die weichmacherhaltige, auf Polyvinylacetal basierende Folie c) Polyvinylacetal mit einem Polyvinylalkoholanteil von weniger als 18 Gew.% enthält und eine Kriechneigung, bestimmt an einem Laminat mit dem Aufbau aus 3 mm Floatglas/ 0,76 mm Folie c) / 3 mm Floatglas, bei einer Temperatur von 100°C nach 7 Tagen von weniger als 5 mm aufweist.

2. Photovoltaikmodul nach Anspruch 1
**dadurch gekennzeichnet, dass** die Polyvinylacetale ein Molekulargewicht Mw von mehr als 110000 g/mol aufweisen.

3. Photovoltaikmodul nach Anspruch 1 oder 2
**dadurch gekennzeichnet, dass** die Polyvinylacetale eine Lösungsviskosität von mehr als 80 mPas aufweisen.

4. Photovoltaikmodul nach einem der Ansprüche 1 bis 3
**dadurch gekennzeichnet, dass** die Polyvinylacetale über Carboxylgruppen, durch Polyaldehyde, Glutardialdehyd oder Glyoxylsäure vernetzt sind.

5. Photovoltaikmodul nach einem der Ansprüche 1 bis 4 **dadurch gekennzeichnet, dass** die Polyvinylacetale durch ein Verfahren mit den Schritten
- Vorlage einer Wässrigen Lösung von Polyvinylalkohol und mindestens einem Aldehyd
- Zugabe von einer Säure unter Ausfallen des Polyvinylacetals bei niedriger Temperatur (Fällphase).
- Aufheizen des Reaktionsgemisches auf eine erhöhte Temperatur (Heizphase)
hergestellt werden, wobei die Fällphase 60 bis 360 min andauert.

6. Photovoltaikmodul nach einem der Ansprüche 1 bis 4 **dadurch gekennzeichnet, dass** die Polyvinylacetale mit einem Verfahren mit den Schritten
- Vorlage einer wässrigen Lösung von Polyvinylalkohol und Säure
- Zugabe von mindestens einem Aldehyd unter Ausfallen des Polyvinylacetals bei niedriger Temperatur (Fällphase)
- Aufheizen des Reaktionsgemisches auf eine erhöhte Temperatur (Heizphase)
hergestellt werden, wobei die Fällphase 60 bis 360 min andauert.

7. Photovoltaikmodul nach einem der Ansprüche 1 bis 6 **dadurch gekennzeichnet, dass** das Polyvinylacetal einen Polyvinylacetatanteil von unter 14 Gew.-% aufweist.

8. Photovoltaikmodul nach einem der Ansprüche 1 bis 7 **dadurch gekennzeichnet, dass** die weichmacherhaltigen, auf Polyvinylacetal basierenden Folien c) einen Weichmachergehalt von 18 bis 32 Gew.-% aufweisen.

9. Photovoltaikmodul nach einem der Ansprüche 1 bis 8 **dadurch gekennzeichnet, dass** als Weichmacher eine oder mehrere Verbindungen eingesetzt werden, deren Polarität, ausgedrückt durch die Formel 100 x O/ (C+H) kleiner/gleich 9.4 ist, wobei O, C und H für die Anzahl der Sauerstoff-, Kohlenstoff- und Wasserstoffatome im jeweiligen Molekül steht.

10. Photovoltaikmodul nach einem der Ansprüche 1 bis 9 **dadurch gekennzeichnet, dass** als Weichmacher eine oder mehrere Verbindungen aus der Gruppe Di-2-ethylhexylsebacat, Di-2-ethylhexyladipat, Di-2-ethylhexylphthalat, Dihexyladipat, Dibutylsebacat, Di-2-butoxyethylsebacat, Triethylenglykol-bis-2-ethylhexanoat und 1,2-Cyclohexandicarbonsäurediisononylester eingesetzt wird.

11. Photovoltaikmodul nach einem der Ansprüche 1 bis 10 **dadurch gekennzeichnet, dass** die weichmacherhaltige, auf Polyvinylacetal basierende Folie weniger als 50 ppm Metallionen enthält.

12. Photovoltaikmodul nach einem der Ansprüche 1 bis 11 **dadurch gekennzeichnet, dass** die weichmacherhaltige, auf Polyvinylacetal basierende Folie 0.001 bis 5 Gew.-% SiO₂ enthält.

13. Photovoltaikmodul nach einem der Ansprüche 1 bis 12 **dadurch gekennzeichnet, dass** als Polyvinylacetal Polyvinylbutyral eingesetzt wird

14. Verwendung von weichmacherhaltigen, auf Polyvinylacetal basierenden Folien mit einem Polyvinylalkoholanteil des Polyvinylacetals von weniger als 18 Gew.% und einer Kriechneigung, bestimmt an einem Laminat mit dem Aufbau aus 3 mm Floatglas/ / 0,76 mm Folie c) / 3 mm Floatglas, bei einer Temperatur von 100°C nach 7 Tagen von weniger als 5 mm zur Herstellung von Photovoltaikmodulen.
